(19) Europäisches Patentamt
European Patent Office
Office européen des brevets

(11) Publication number: **0 227 002 B1**

(12) # EUROPEAN PATENT SPECIFICATION

(45) Date of publication of patent specification: **16.12.92**

(51) Int. Cl.5: **C09J 167/00**, C09J 163/00, C09J 175/00, H05K 3/22

(21) Application number: **86117457.1**

(22) Date of filing: **16.12.86**

(54) **Heat activatable adhesives for wire scribed circuit boards.**

(30) Priority: **20.12.85 US 811421**

(43) Date of publication of application:
**01.07.87 Bulletin 87/27**

(45) Publication of the grant of the patent:
**16.12.92 Bulletin 92/51**

(84) Designated Contracting States:
**AT CH IT LI SE**

(56) References cited:
**EP-A- 0 003 040**
**EP-A- 0 097 815**
**US-A- 3 321 549**

(73) Proprietor: **Advanced Interconnection Technology, Inc.**
**181 Freeman Avenue**
**Islip, NY 11751(US)**

(72) Inventor: **Friedrich, Marju Laube**
**165 Peninsula Drive**
**Babylon, NY 11702(US)**

(74) Representative: **Königseder-Egerer, Claudia D.**
**Zugspitzstrasse 65**
**W-8104 Grainau(DE)**

EP 0 227 002 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a polymeric resin containing adhesive coating composition which can be heat activated without C-staging of the polymeric resin and, later, the polymeric resin can be C-staged, a wire scribed circuit board using said adhesive composition for embedding a wire conductor, and a process for forming the wire scribed circuit board.

Heat activatable adhesive compositions can be applied to a substrate as a thin, non-tacky film, can be heat activated and, when activated, become and remain tacky for a period of time after activation. Most heat activated thermoplastic adhesives resolidify rapidly upon cooling and have a short open time, i.e., after activation, the adhesive remains aggressively tacky and bondable below the activation temperature for only a short time. Bonding operations must be carried out quickly.

In many bonding operations, it is necessary to employ adhesive compositions which result in adhesive bonds exhibiting resistance to degradation at elevated temperatures. It is known that improved temperature resistance of adhesive compositions can be achieved by the incorporation of crosslinking components. Particular crosslinking components known in the art include the polyepoxides and optional epoxy polymerization catalysts described in US patent 3 723 568 wherein crosslinking is achieved by reactions with available sites in the base polymer.

US patent 4 137 364 describes crosslinking of an ethylene/vinyl acetate/vinyl alcohol terpolymer using isophthaloyol biscaprolactum or vinyl triethoxy silane. Crosslinking is achieved before heat reactivation. A higher level of performance is attained by additional crosslinking induced by a heat cure after application of the adhesive. Another example of thermal crosslinking compositions is the polyamino bis maleimide class of flexible polyimides described in US patent 4 116 937. The therein described compositions can be hot melt extruded up to 150 °C and undergo crosslinking at temperatures above 150 °C. In both of these examples, thermal crosslinking is achieved by reactions of the particular crosslinking agent with available sites of the base polymers.

Thermosetting adhesive compositions are known which combine polyisocyanates with binders containing groups that are reactive toward isocyanate groups. However, considerable difficulties result from the fact that the isocyanate groups react with the envisaged reactant, e.g., a polyol or a polyamine, at as low as room temperature. As a result, it is extremely difficult to formulate a combination having a long shelf life.

In order to overcome this difficulty, two-component systems are frequently used. The reactants are stored in separate formulations, which are mixed only just before application; the reaction then takes place spontaneously or is accelerated by heat and/or a catalyst.

Disadvantages of this system are the necessity for separate formulatiun and storage of the two components, the difficulties in precise metering and thorough mixing before application, and the danger of blockage of the mixing apparatus and applicator as a result of premature reaction.

A conventional method of preparing polyisocyanate materials having a long shelf life starts from non-crosslinked prepolymers which contain only a small amount of free isocyanate, atmospheric moisture serving as the crosslinking agent. This method is described in, e.g., French patent 1 237 936. The disadvantage is that the hardening, which begins at the surface, extends only very slowly to the deeper regions of the coating, so that the final properties are acquired only after weeks or months. No hardening at all occurs between large areas or in cavities.

Stable systems also can be fomulated if the polyisocyanate is first reacted with a monofunctional reactant. The resulting adduct is referred to as a blocked isocyanate if it is less heat-stable than the product of the crosslinking reaction to be carried out subsequently. Under the action of heat, the blocking agent is eliminated, and the polyisocyanate undergoes crosslinking, forming more heat stable bonds.

Because of the blocking agent to be eliminated, such formulations have techical and economical disadvantages: if the blocking agent remains in the crosslinked material, it changes the properties of the latter; if it vaporizes, it either has to be recovered or has to be otherwise removed from the waste air.

US patents 3 475 200, 4 251 427 and 4 251 428 describe polyisocyanates which melt at above 100 °C and at above 130 °C, respectively, and which, with special polyols, give combinations which have long shelf lives and which can be hardened by heating to give coatings for fabrics or woven hoses.

The industrial disadvantages of the combinations described in the above patents is that products having a long shelf life can be obtained only with a very small number of polyols having a special composition; therefore, these combinations are, for example, completely suitable only for a limited number of uses.

US patent 4 093 675 describes an adhesion composition containing a poly(ester/ether) block copolymer (I) with terminal OH, which is chain extended and carboxylated with a dianhydride, to form a carboxylated poly(ester/ ether) block copolymer having the formula

$-[O{-}{-}{-}OOC{-}R(COOH)_2{-}CO]_{\overline{n}}$

wherein -O---O- is a poly(ester/ether) block copolymer; R is alykl, cycloalkyl or aryl; and n is 1 to 2. The thermoplastic block copolymer may be hardened to a thermosetting copolymer which contains a crosslinked component as well as a linear, flexible copolymer component. The crosslinked copolymer is a block copolymer in which one of the blocks itself is a block copolymer, and can resist creep at 150 °C.

US patent 4 430 479 describes an adhesive composition which comprises a thermoplastic polymer (I); 1 to 100 parts by weight of a crosslinkable polymer (II) being a hydroxy-substituted polyester of polyacrylate or a polyamine; and a crosslinking agent, preferably a di-or polyisocyanate. (I) is preferably a polyester, polyurethane, polyamide, rubber or ethylene/ vinyl acetate polymer, and optionally contains up to 100 parts by weight per 100 parts by weight of a conventional tackifying resin (typically hydrogenated and dehydrogenated resin esters). The composition has good adhesive strength, exhibits delayed tack on heat activation which is achieved at relatively low temperature, and shows high temperature resistance. It is non-blocking and may be applied to substrates well in advance (about 60 days) of the actual bonding operation.

US patent 4 194 618 describes a coated abrasive article comprising a backing member having abrasive grains adhered thereto. The article has two of its ends joined together by a layer of an adhesive composition, which in its initial state is a preformed adhesive film which has been partially cured but which can still be activated at a temperature suitable for splicing the ends together. The adhesive film is the reaction product of an adhesive composition comprising a mixture of (a) a hydroxy-terminated polyurethane-polyester of hydroxyl No. 2-15; (b) an active hydrogen component having an active hydrogen equivalent weight of 27 to 500; (c) a component having free available isocyanate groups; and (d) a chlorinated aliphatic hydrocarbon, chlorinated aromatic hydrocarbon and/or alkylated poly_styrene, this component (d) being miscible with components (a), (b) and (c).

US patent 4 476 259 describes a solvent based thermosetting composition comprising a hydroxy functional epoxy ester resin having a number average molecular weight (Mw) between 1 000 and about 5 000; and a polyfunctional hydroxy-reactive, crosslinking agent. The epoxy ester resin is formed by the reaction of diepoxide, which has been chain extended with diphenol and dicarboxylic acid, with a hydroxyfunctional, secondary amine in a chain terminating reaction, in preferably a 1:1 equivalent ratio. The crosslinking agent is an amine crosslinker or a blocked isocyanate crosslinking agent comprising isocyanate groups blocked by reaction with an active hydrogen bearing blocking agent.

US patents 3 646 572 and 4 097 684 describe a catalytic adhesive for wire scribed circuit boards which comprises a flexible adhesive resin, alone or in combination with thermosetting resins. The flexible adhesive resins include epoxy resins, polyvinyl acetal resins, polyvinyl alcohol, polyvinyl acetate, natural and synthetic rubbers and acrylic polymers and copolymers. Preferred for use as the adhesive resin are natural and synthetic rubbers such as chlorinated rubber, butadiene-acrylonitrile copolymers, and acrylic polymers and copolymers.

The use of this adhesive in a process for manufacturing wire interconnection boards is mentioned in US patents 3 674 602 and 3 674 914. The adhesive layer is in the form of a partially cured thermosetting resin which is non-tacky at room temperature, but which, upon application of heat below the thermosetting temperature, becomes malleable and provides an adhesive bond when heated momentarily and cooled. In a step of the aforementioned process, after the wire conductor pattern is completed, it is permanently bonded to the substrate by pressing the wire conductors into the adhesive layer with heat and pressure further curing the adhesive, or by covering the wire conductors with a glass cloth reinforced, epoxy prepreg and then laminating the wire conductors into the adhesive with heat and pressure. Adhesive compositions based upon those described in US patents 3 646 572 and 4 097 684 have been used commercially in the manufacture of wire scribed circuit boards for many years.

It was found that, in the aforementioned laminating step, occasionally, wire conductors laid down in the correct position frequently would "swim" away when a cover layer of epoxy impregnated fiberglass was laminated over the wire conductors under heat and pressure. The hydraulic pressure of the melted epoxy resin, and partially melted adhesive layer beneath, moved the wire conductors. Attempts to eliminate the wire swimming by increasing the partial cure of the adhesive before wiring, or by baking after the wire conductor pattern had been completed, or by modifying the laminating conditions were not successful.

The volume resistivity of adhesive layers of the type described in the aforementioned patents is about $1 \times 10^4$ to $1 \times 10^6$ Megohm-cm because high rubber content is needed to give tack for ultrasonic or heat bonding of the wire to the adhesive. In some applications requiring high insulation resistance, higher volume resistivity is preferred.

US patent 4 427 478 describes the use of a photochemically curable adhesive for encapsulating wires on a wire scribed circuit board. The adhesive is a mixture of acrylate esters of epoxy novolac resins and

bisphenol A epoxy resins. The adhesive is deposited on a substrate and after wires are laid therein, it is partially light cured in an attempt to prevent wire swimming. At a later step, the adhesive is photochemically or thermally cured fully to rigidly fix the wires on the substrate.

EP-A 0 097 815 describes a photocurable adhesive for holding wires on a circuit board, the adhesive comprising bisphenol A based epoxy resin of molecular weight 1 500 - 5 000, an epoxidized novolac of molecular weight 900 - 1 500, a monoethylenically unsaturated carboxylic acid, a catalyst, a polyethylenically unsaturated compound, a photoinitiator, a phenoxy resin with a molecular weight above 30 000, and a thixotropic agent.

GB patent 1 504 252 suggests wire scribing using a thermosetting adhesive layer which is deposited over a substrate except for surfaces thereof where solder connections are subsequently to be made. There is, however, no suitable or preferred adhesive composition described.

It is an object of the invention to provide a polymeric resin containing adhesive coating composition which is activatable upon application of sufficient heat or ultrasonic energy without C-staging the polymeric resin, and which, at a later step, can be C-staged.

An object of the invention is to provide an adhesive coating composition which is suitable for bonding a wire to a surface.

It also is an object of the invention to provide an adhesive coating composition for wire scribed circuits with a volume resistivity over the temperature range of 20°C to 120°C which is at least one order of magnitude, and preferably at least two orders of magnitude, greater than the volume resistivity of adhesive compositions of the type described in US patents 3 646 572 and 4 097 684.

An object of the invention is to provide a solid, adhesive composition containing a polymeric resin which can be C-staged prior to an encapsulation step to substantially eliminate wire swimming in subsequent processing steps. Another object of this invention is to provide a solid, adhesive composition which is non-tacky at room temperature and is ultrasonically or heat activatable.

It is also an object of this invention to provide an adhesive composition which may contain up to 25% volatiles for facile ultrasonic activation, and also remains non-tacky in the absence of heat and pressure.

It is a further object of this invention to provide an adhesive coating composition for wire scribed interconnection boards containing little or no natural or synthetic rubbers or elastomers.

Another object of the invention is to provide a thermosetting adhesive coating composition which can behave like a hot melt adhesive, i.e., it is activated to its tacky state when heated to or above its melting range, and thereafter rapidly resolidifies when cooled to below said melting range, and which also can be thermo_set by ultraviolet radiation.

A further object of this invention is to provide an adhesive coating composition which can adhere a 0.1 mm diameter wire to an insulating substrate with a bond strength greater than 30 g, preferably greater than 40 g.

A still further object of this invention is to provide a wire scribed circuit board having an insulation resistance of at least 1 x $10^5$ megohms.

Unless otherwise defined herein, the terms used in this application are defined as set forth in the American Society for Testing and Materials Standard D-907-82.

By 'heat activatable adhesive' is meant a dry adhesive film that can be rendered tacky or fluid by application of heat, heat and pressure, or ultrasonic energy.

By 'B-stage' is meant an intermediate stage in the reaction of certain thermosetting resins in which the material softens when heated and swells when in contact with certain liquids, but may not entirely fuse or dissolve. The resin in an uncured thermosetting adhesive is usually in this B-stage.

By 'blocked curing agent' is meant a curing agent or hardener which has been rendered unreactive and can be reactivated as desired by physical or chemical means.

By 'bond strength' is meant the unit load applied in tension, compression, flexure, peel, impact, cleavage, or shear, required to break an adhesive assembly with failure occurring in or near the plane of the bond.

By 'C-stage' is meant the final stage in the reaction of certain thermosetting resins in which the material is relatively insoluble and infusible. Certain thermosetting resins in a fully cured adhesive layer are in this stage.

By 'doctor roll' is meant a roller mechanism that is revolving at a different surface speed, or in an opposite direction to that of a spreader roll, thus resulting in a wiping action for regulating the adhesive supplied to the spreader roll.

By 'filler' is meant a relatively non-adhesive substance added to an adhesive to improve its working properties, permanence, strength, or other qualities.

By 'plasticizer' is meant a material incorporated in an adhesive to increase its flexibility, workability, or

distensibility.

By 'tack' is meant the property of an adhesive that enables it to form a bond of measurable strength immediately after adhesive and adherent are brought into contact under low pressure.

By 'thermoplastic' is meant a material that will repeatably soften when heated and harden when cooled.

By 'thermoset' is meant a material that will undergo or has undergone a chemical reaction by the action of heat, catalysts, UV light, etc., leading to a relatively infusible state.

By '$T_g$' is meant the glass transition temperature, the temperature at which an amorphous high polymer changes from a brittle vitreous state to a plastic state.

By 'onset of $T_g$' is meant the beginning of a glass transition in a blend of polymers in an adhesive as measured by differential scanning calorimetry or thermal mechanical analysis.

By 'wire scribing' is meant affixing a wire to an insulating base to form an interconnection pattern.

This invention relates to a process for forming a wire scribed circuit wherein at least one adhesive layer is applied to a substrate and at least one wire conductor is scribed into the adhesive layer, characterized in that (A) the wire conductor(s) is (are) adhesively bonded by application of sufficient heat or ultrasonic energy for a time period of less than 1 second, without C-staging the adhesive layer, and the adhesive layer is C-staged at a later process step; and (B) the adhesive comprises, in combination, (a) a first component comprised of a film forming polymeric resin having a number average molecular weight greater than 10 000 and a hydroxyl, epoxide or unsaturated functionality greater than 7, said resin being selected from the group of polyols consisting of polyesters, polyurethanes, phenoxies, epoxies and mixtures thereof; (b) a second component comprised of a plasticizer present in an amount which permits the activation without curing the composition to the C-stage, said plasticizer being a volatile organic solvent having a boiling point above 100 ° C, a reactive diluent which can be crosslinked with the polymeric resin, or mixtures thereof with an aromatic petroleum oil which does not volatilize or exude from the composition below 160 ° C, said organic solvent being present in an amount less than 25% by weight of the adhesive composition; and (c) a curing agent which is capable of reacting or initiating a reaction with the functional groups of the polymeric resin to form crosslinks and cure the polymeric resin to a C-stage upon application of sufficient energy in the form of radiant energy or heat at a temperature above the activation temperature of the composition for a time period sufficient to cure the polymeric resin, said curing agent being non-reactive or blocked at the conditions required to activate the adhesive composition, said curing agent being present in an amount sufficient to C-stage the polymeric resin; said composition being capable of converting in the C-stage into an infusible composition which does not melt or flow, upon exposure to a temperature up to 200 ° C and a pressure up to 3 MPa, in a plane perpendicular to the direction of the applied pressure; and (C) substantially all the solvent plasticizer is evaporated or substantially all the diluent plasticizer is reacted prior to the completion of the C-staging step; and (D) after scribing the wire conductors into the adhesive layer, said layer is cured to C-stage the polymeric resin, thus preventing movement or swimming of the wire conductors subsequent to the wire scribing process.

The invention further relates to a wire scribed circuit board made in accordance to the claimed process.

The film forming polymeric resins useful in the invention have a molecular weight sufficiently high to be good film formers, and should be non-tacky when dry. Suitable film forming polymeric resins useful in the adhesive compositions of this invention include those polyols having a hydroxyl, epoxide or unsaturated functionality greater than 7, preferably greater than 20, and are selected from polyesters, epoxies, polyurethanes, and phenoxy resins and mixtures thereof. The functionality is available for crosslinking with a curing agent to C-stage the polymeric resin in the adhesive composition. Examples of unsaturated functional groups include vinyl, allylic, methallylic, acrylic and methacrylic groups. In one embodiment,the functional groups of the film forming polymeric resin are hydroxyl and the curing agent is a blocked polyisocyanate. In another embodiment, the functional groups of the film forming polymeric resin are unsaturated double bonds such as acrylic and allylic groups, and the curing agent is a free radical initiator. It has been found that phenoxy resins such as poly(4,4'-isopropylidenediphenol-1,3-glyceryl ether) having the recurring structural unit

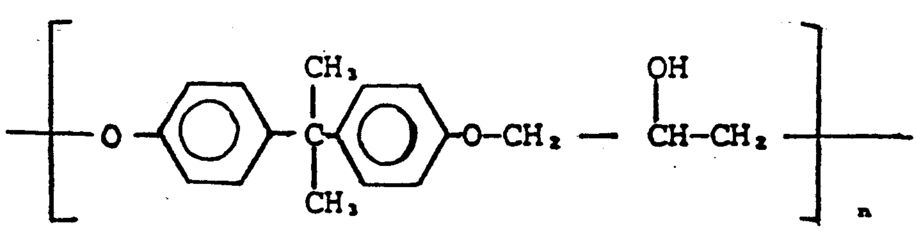

where n is an integer from 20 to 350, are particularly useful in the adhesive compositions of this invention. Such phenoxy resins are linear and may have one or two terminal oxirane groups. Phenoxies are properly regarded as thermoplastic materials.

Suitable polyesters are believed to include those prepared from (1) one or more diacids selected from saturated and unsaturated aliphatic dicarboxylic acids containing from 4 to 10 carbon atoms, aromatic dicarboxylic acids such as terephthalic acid, isophthalic acid, phthalic acid, 4,4'-diphenylthioether dicarboxylic acid, 4,4'-diphenylamine dicarboxylic acid, and saturated and unsaturated aliphatic dimer acids (i.e., the polymerized product of two molecules of an unsaturated fatty acid containing 12 to 26 carbon atoms) and mixtures and derivatives thereof; and (2) one or more unsaturated or saturated aliphatic diols containing from 2 to 12 carbon atoms, long chain aliphatic diols having an average molecular weight of from 200 to 4 000, polyethylene oxide and polypropylene oxide polymers and copolymers, and allyl ethers of polyethylene and polypropylene oxide, and polyhydroxyl compounds such as glycerin, trimethylolpropane and neopentyl alcohol and mixtures and derivatives thereof.

Suitable epoxy resins are believed to include diglycidylethers of bisphenol A having epoxy equivalent weights of from 400 to 6 000, diglycidylethers of halogenated bisphenol A having epoxy equivalent weights of from 450 to 2 000, epoxy novolacs or polyglycidyl ethers of phenolformaldehyde, polyglycidyl ethers of tetraphenylethane and polyglycidyl ethers of resorcinol. Also believed to be suitable are very high molecular weight copolymers of bisphenol A and epichlorhydrin with weight average molecular weights greater than 50 000 and number average molecular weights greater than 10 000, and preferably greater than 15 000. Preferred epoxy resins are diglycidyl ethers of bisphenol A having epoxy equivalent weights of from 1 000 to 6 000.

Suitable polyurethanes are believed to include the reaction products of diisocyanatea and polyesters, polyethers or polyester/polyether copolymers. Preferred polyurethanes are those containing aliphatic linkages of 100 to 1000 molecular weights and some aromatic groups (e.g., isophthalate or terphthalate ester groups or toluene diurethane groups).

Suitable film forming polymeric resins according to the invention may be obtained by using one or more polyols intrinsically having a number average molecular weight greater than 10 000, preferably greater than 15 000, or by reacting a low molecular weight polyol selected from the group of polyols consisting of polyesters, polyurethanes, polyethers, epoxies, and combinations thereof to a B-stage with a curing agent which is present either in less than a stoichiometric quantity or is capable of reacting with functional groups that were present at low concentrations on the polymer chain so that the B-staged polymeric resin has the aforementioned high number average molecular weight. Preferably, the curing agent used for B-staging the low molecular weight polyol is an isocyanate or an amide.

The film forming polymeric resins of this invention provide adhesion, chemical and thermal resistance and flexibility for the adhesive composition. Adhesion to a variety of surfaces is enhanced by polar groups along the polymer chain. Hydroxyl groups on the backbone of a phenoxy resin are one example of suitable polar groups. Flexibility of the adhesive composition is provided by internal plasticization of aliphatic portions of the polymeric resin. Thermal resistance of the adhesive composition is enhanced by the presence of aromatic groups in a repeating pattern along the polymer backbone. Chemical resistance is enhanced by the presence of the aromatic groups as well as ether linkages in a repeating pattern on the polymer backbone. The ether linkages are stable in alkalis and in inorganic acids.

Plasticizers suitable for this invention are selected so that they do not degrade the properties of the C-staged adhesive composition. Prior to C-staging, the plasticizer should be compatible with the polymeric resin, i.e., it does not separate from the adhesive composition. The plasticizer should soften the adhesive composition and adjust the softening point or the onset of $T_g$ of the adhesive to a range suitable for heat or ultrasonic activation,i.e., the onset of $T_g$ is preferably adjusted to between -5°C and +15°C, and preferably between 4°C and 10°C.

One group of plasticizers are volatile and can be vaporized prior to C-staging and subsequent to formation of a bond between the adhesive composition and a wire conductor. Suitable volatile plasticizers are solvents for the polymeric resins. Suitable organic solvents are those having boiling points above 100°C, preferably above 120°C, and include glycol ethers such as ethers of ethylene glycol or propylene glycol with aliphatic groups having 1 to 4 carbon atoms; glycol ether esters such as acetates of methyl, ethyl and propyl ethylene glycol ethers; ketones having from 6 to 9 carbon atoms such as methylbutyl ketone, methyl isoamyl ketone, ethyl amyl ketone, methyl heptyl ketone, n-methylpyrrolidone and cyclohexanone; aromatic hydrocarbons such as xylene and toluene; and substituted aromatic hydrocarbons such as cresol.

A second group of plasticizers are reactive diluents and can be crosslinked with the polymeric resin and thereby from part of the C-staged composition. Suitable reactive diluent plasticizers include acrylate and

methacrylate esters having boiling points above 100°C, and low molecular weight mono- or diepoxide compounds such as neopentyl diglycidyl ether, butyl glycidyl ether and the like.

A third group of plasticizers which are used in combination with one or both of the first two groups of plasticizers are high boiling oils which do not volatilize or exude from the adhesive composition below 160°C, preferably below 300°C. Suitable high boiling oils are believed to include aromatic oils, e.g., an aromatic petroleum oil having a boiling point above 315°C and believed to consist of 96.2% aromatic oil and 3.8% paraffinic oil.

Applicant has found possible, by controlling the amount and type of crosslinking introduced into a C-stageable adhesive coating composition,to render said composition heat activatable until the polymeric resin in said composition is C-staged. Thus, until the polymeric resin in the adhesive composition of this invention is C-staged, the composition can be rendered tacky upon application of sufficient heat or ultrasonic energy and will rapidly resolidify upon cooling, i.e., upon dissipation of said energy. The polymeric resin in the resolidified adhesive composition can be C-staged which will increase the temperature resistance of the composition without altering other desirable properties, i.e., the dimensional stability and adhesive strength of the composition. In preferred compositions, for example, crosslinking is achieved at a temperature higher than that required for heat activation through use of a polyol as defined above having a hydroxy, epoxide or unsaturated functionality greater than 20 and a blocked isocyanate crosslinking agent capable of reacting with the polyol, or an ultraviolet curing agent capable of initiating crosslinking with functional groups of the polyol.

The selection of the curing agent to crosslink the functional groups and cure the polymeric resin in the adehsive composition to a C-stage will depend on the functional groups available. If they are hydroxyl, the curing agent may be selected from polyisocyanates, ureamelamine resins, phenols and compounds containing phenolic hydroxyl groups. Among the polyisocyanates are blocked polyisocyanates which unblock at temperatures above 75°C, preferably above 100°C. Suitable blocked polyisocyanate curing agents are believed to include those described in US patent 4 476 259.

If the functional groups available in the B-staged adhesive composition are epoxide, the curing agent is selected from latent epoxy curing agents such as dicyandiamide and the boron trifluoride-monoethylemine complex. Other latent curing agent systems believed to be suitable include anhydride curing agents with latent catalysts. Anhydride curing agents include dodecenyl succinic anhydride, chlorendic anhydride, hexahydrophthalic anhydride, NADIC methyl anhydride, phthalic anhydride, succinic anhydride and tetrahydrophthalic anhydride. Latent catalysts for use with anhydride curing agents include boron trifluoride monoethylamine complexes, quaternary ammonium halides such as benzyltrimethyl ammonium chloride, stannous octoate, zinc stearate, extracoordinate siliconate salts, triethanolamine borate, triethynolamine titanate, and quaternary phosphonium compounds such as methyltrioctyl-phosphonium dimethyl phosphate, tetrabutyl phosphonium acetate, methyltributyl phosphonium dimethyl phosphate, benzyltriphenyl phosphonium chloride, tetrabutyl phosphonium chloride, methyltriphenyl phosphonium dimethyl phosphate and triphenylethyl phosphonium iodide. Also suitable for crosslinking epoxide groups are blocked Lewis acid catalysts which can be unblocked by ultraviolet radiation. The blocked Lewis acid catalysts include aromatic iodonium complex salts and aromatic sulfonium complex salts, e.g., triphenyl sulfonium hexafluorantimonate and triphenyl sulfonium hexafluorophosphate.

If the functional groups available for curing the polymeric resin in the adhesive composition to a C-stage are unsaturated carbon-carbon double bonds, a free radical initiator is used as curing agent. Suitable free radical initiators which are activated by heat include 1,1′-azobis(cyclohexane carbonitrile), dicumyl peroxide, 1,1′-bis(ter-butylperoxy)-diisopropylbenzene and the like. Suitable free radical photoinitiators include benzoin, benzoin alkyl ethers, benzil ketals, dialkoxyacetophenones, di- and trichloroacetophenones, benzophenone, 4,4′-dimethylaminobenzophenone, thioxanthone derivatives such as thioxanthone, 2-chlorothioxanthone, 2-methylthioxanthone, 2-ethylthioxanthone and the like, fluorenone, dibenzosuberone, 6,11-dihydrodibenzothiepin-11-one, and quinones such as anthraquinone, 2-ethylanthraquinone, tertiary butyl anthraquinone, and anthraquinone sulfonate. Preferred is 2,2-dimethoxyphenyl-2-acetophenone.

The adhesive composition may contain one or more additives such as fillers, pigments,organic coupling agents (for bonding a filler to a polymer), slip agents, flow agents, and the like. Suitable conventional additives are well known to those skilled in the art.

A filler enhances the non-tacky properties of the solid adhesive composition. Moreover, the filler reinforces, and controls, shrinkage during cure of the adhesive composition. Fillers are usually inorganic particles, granular in shape, which are not expected to improve strength. Fillers generally reduce shrinkage, lower exotherm, improve machineability and, with proper selection, improve electrical properties and thermal conductivity. Reinforcements which are fibrous, such as glass fiber and mica, increase strength and heat resistance, and reduce shrinkage and thermal expansion. Examples of suitable fillers include inorganic

carbonates, oxides, sulfates, sulfides, calcium carbonate, calcium sulfate, barytes, blanc fixe, zinc sulfide, silica, diatomaceous earth, clays, magnesium silicate, wollastonite, alumina hydrate, zinc oxide, titanium dioxide, zirconias, zirconium silicate, talcs, calcium carbonate, silicon carbide and organic fillers such as organic pigments and insoluble polymer powders. Preferred are mica, fumed silica and zirconium silicate.

Pigments may be added to the adhesive composition as fillers and to provide color and/or capacity, if desired. Conventional pigments may be employed and are well known to those skilled in the art.

Titanate coupling agents are molecular bridges at the interface between an inorganic filler and an organic polymer matrix. Fillers have a tendency to settle out of the solutions of the adhesive composition. It has been found by applicant that the incorporation of titanate coupling agents substantially reduces the settling. It is believed that dispersion of an inorganic in an organic phase, in the presence of titanate coupling agents, is enhanced by the replacement of the water of hydration at the inorganic surface with a monomolecular layer or organic functional titanate causing inorganic/organic phase compatibility at the interface, thereby increasing the degree of displacement of air by the organic phase in the voids of the inorganic phase.

Flow aids (or levelling agents) may be used to improve the flow of solutions of the adhesive composition when coating a base or a carrier sheet. Cellulose derivatives and linear polymers are especially useful, e.g., polyvinyl acetate, silicone oils, and MODAFLOW ™ (believed to be a butyl acrylate polymer). Other levelling agents and flow aids include aluminum stearate, calcium stearate, sucrose benzoate, and high molecular weight non-ionic surface active agents.

Thixotropic agents are useful in controlling viscosity of adhesive solutions when the adhesive solutions are applied to a base or a carrier sheet. They also help to maintain different materials in dispersion and prevent phase separation. Examples of thixotropic agents are Bentone ™, and organic base salt of a clay mineral, e.g, montmorillonite, and other silicate materials, aluminum, calcium, and zinc salts of fatty acids such as lauric or stearic acid, and fumed silicas such as Cab-o-Sil ™ , a fumed silica having an average particle size greater than 200 $m^2/g$, and Santocel ™.

Suitable deaeration agents assist bubble release in roller applications. Good results have been obtained with special mixed polymers of vinyl isobutyl ether and acrylic esters with a maximum level of 0.05% based on resin solids. Modaflow ™ also can be used as a deaeration additive in the manner described. Other suitable deaeration agents include reacted mineral oils, e.g., Baylab 3056A ™ or antifoams, e.g., defoamers Byk-S1 ™ and Byk-0 ™, and Foam Kill 8D ™ and Foam Kill Silicone Antifoam Compound ™.

Catalysts for electroless metal deposition may be included in the adhesive composition. Such catalysts are used to initiate electroless plating of plated through holes in wire scribed boards. For example, a catalytic filler such as an aluminum silicate clay provided with 1 to 2% palladium as described in US patent 3 546 009 may be incorporated in the adhesive composition. Another suitable catalyst for electroless metal deposition which may be incorporated in the adhesive composition is 1% palladium reacted with an 85% solution of diglycidyl ether of bisphenol A in dimethylformamide.

The adhesive coating compositions of this invention may be applied to substrates well in advance of the actual bonding operation. The composition may be simply activated by heat, radiant or ultrasonic energy when it is desired to perform the bonding operation.

Regarding the means of application, the adhesive compositions of the invention may be applied to carrier sheets or directly to substrates as solutions in volatile organic solvents by methods common to solvent-based adhesives, i.e., spray coating, doctor-blade coating, roll coating, doctor-roll coating and the like. The adhesive coating compositions may be conveniently spray applied to substrates as solutions in volatile organic solvents using conventional spray equipment. The result in any case is a non-tacky, solid, crosslinkable adhesive layer which dries quickly in air and which can be heat activated immediately or thereafter up to the time it is C-staged. In use, it has been found convenient to coat the film onto a releasable liner such as a polyester film having a release coating, e.g., a silicone release coating. The adhesive coating composition may be peeled away from the releasable liner when desired for a particular application. The adhesive coating compositions of this invention may be applied to substrates as films having a uniform thickness between about 50 and about 150 µm by platen pressing, hot roll lamination and vacuum lamination.

The adhesive coating compositions of this invention have many advantageous properties. They are useful for forming wire scribed circuits, for encapsulating wires or as an adhesive layer on a substrate such as a printed wiring board. The property of being non-tacky when in the solid form allows the adhesive coated substrate to be handled during the processing steps of forming a wire scribed circuit board. It also allows the adhesive coated substrate to be wired without fouling the wire positioning mechanism. Further, the non-tacky surface does not attract and hold debris. The heat activatable property of the composition prior to C-staging of the polymeric resin allows a wire which is placed on an activated adhesive coated

substrate to adhere rapidly and easily. The C-stageable property of the polymeric resin allows the adhesive composition to be an excellent insulator, and to withstand high temperature service and harsh chemical environments. When used in the manufacture of a wire scribed circuit board, the C-staged adhesive composition keeps overall wire movement during subsequent lamination steps to less than 0.15 mm/m between wires.

The adhesive bond between the wire and the substrate may be measured by vertically peeling the wire in a direction away from and perpendicular to the board surface, or, alternatively, horizontally peeling the wire in a direction along the board surface which is transverse to the cylindrical axis of the wire. An adhesive according to this invention should be capable of bonding a 0.1 mm diameter wire with a peel strength of 30 to 60 g before curing to a C-stage.

EXAMPLE I

A phenoxy coating composition suitable as an adhesive layer for wire scribed circuit boards was prepared as follows:

1. Phenoxy resin — 13.78 kg
   32% phenoxy resin dissolved in 2-ethyoxy-ethylacetate. The phenoxy resin is a poly-[p,p-isopropylidene-diphenoxy-(hydroxyethyl)-ether] having from 23 to 350 monomer units per molecule, and terminal epoxide or phenol groups. The weight average molecular weight, $M_w$, was 300 000 and its number average molecular weight, $M_n$, 20 000.
2. Blocked aromatic polyisocyanate — 3.58 kg
   which will unblock at 125 to 160°C. (The blocked polyisocyanate is 60% solids dissolved in a 50/50 mixture of xylene and 2-ethoxyethylacetate.
3. Phlogopite mica powder (325 mesh) — 0.13 kg
4. Zirconium silicate powder (average particle size 0.55 μm) — 0.13 kg
5. Fumed silica — 0.053 kg
   having a surface area of 200 m²/g
6. Organic titanate coupling agent — 1.6 g
   The chemical formula of the organic titanate was

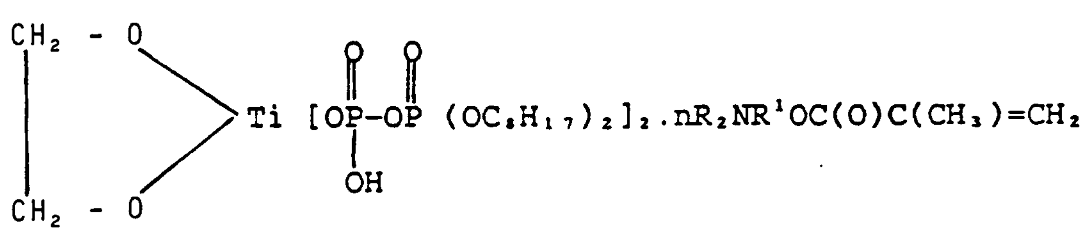

7. Aluminum silicate clay 0.22 kg
having 16 mg of palladium per gram prepared by the procedures of US patent 3 546 009.

The above listed ingredients were mixed together in a high shear mixer (Cowles Dispersator TM ) for five min. and then an epoxy resin solution was added as follows:

8. Polyglycidylether of Bisphenol A (dry) 2.22 kg
with a weight average molecular weight, $M_w$, of 44 000 and a number average molecular weight, $M_n$, of 11 000, as a 46% solids solution in a mixture of 92.5% 2-hydroxymethoxypropane and 7.5% methyl isoamyl ketone.

The combined ingredients were milled on a three roll paint mill into a uniform adhesive solution.

The thus obtained adhesive solution was doctor-roll coated onto a release treated polyethyleneterphthalate film. The adhesive solution layer had a wet film thickness of 0.4 mm. The coated film was passed through a three stage hot air drying oven. The first stage was at 65 °C, and the second and third stages were at 77 °C. The total time in the oven was 7 minutes. After drying, the polyethyleneterphthalate film coated with the adhesive layer was wound into a roll. The adhesive layer was a non-tacky, dry film containing 22% residual solvent, primarily 2-ethoxy ethylacetate, and had a dry film thickness of 0.1 mm. Although non-tacky, the adhesive layer was not non-blocking, so the polyethyleneterphthalate film had a release coating on both sides.

Then an adhesive layer on a polyethyleneterphthalate film was hot roll laminated over an epoxy-glass laminate at a temperature of 70 °C. The polyethyleneterphthalate film was removed, and a circuit pattern was scribed into the adhesive surface with 0.1 mm diameter insulated Cu-wire, the wire having a polyimide insulation with a minimum thickness of 0.023 mm and an outer coating of polyvinyl butyral with a minimum thickness of 0.01 mm. The wire scribed circuit was baked at 80 °C for one hour to remove residual solvent and then at 160 °C for one hour to unblock the polyisocyanate which formed crosslinks with the phenoxy and poly(glycidyl bisphenol A) resins and C-staged the adhesive layer. After curing the adhesive layer, the adhesion between the scribed wires and the C-staged adhesive substrate was 60 N.

The wire scribed circuit pattern was covered with a layer of prepreg by laminating at 160 °C and 2.4 MPa to protect the wire pattern and provide a rugged interconnection package. After lamination, the scribed wires were all in the predetermined position, and there had been no movement or swimming of the wires during the lamination process. The thus laminated wire scribed circuit board was then provided with a protective plating mask, drilled to form through-holes, plated in order to metallize said through-holes, and the protective plating mask was removed. The insulation resistance of the wire scribed circuit board formed in this way was then measured in accordance with the procedures outlined in MIL-STD-202, Methods 106 and 302. All measurements were made using a high resistance meter with an applied potential of 100 V DC. The insulation resistance was determined to be in the range of $10^6$ megohms.

For comparison, another epoxy glass laminate with an etched power and ground connection pattern was processed by the conventional wire scribing technique. The adhesive had the following composition:

| | |
|---|---|
| Acrylonitrile butadiene copolymer rubber | 26.9 % |
| Alkyl phenolic resole resin | 13.4 % |
| Diglycidyl ether of Bisphenol A, $M_W$= 1 000 | 9.0 % |
| Chlorosulfonated polyethylene rubber | 9.0 % |
| Phenolic novolac resin containing hexamethylenetriamine | 13.4 % |
| Zirconium silicate filler | 17.9 % |
| Palladium chloride reacted with a liquid epoxy resin | 2.7 % |
| Fumed silica | 4.5 % |
| Flow agent | 0.5 % |
| Copper phthalocyanine pigment | 2.7 % |

The adhesive had been coated on both sides of an epoxy prepreg, 0.1 mm thick on one side and 0.05 mm thick on the other side. The adhesive was laminated with a hot roll laminator over the epoxy-glass laminate and etched copper patterns.

A wire circuit pattern was scribed into the adhesive. After the wire scribed circuit pattern was formed, the adhesive was baked for one hour at 93°C to cure the adhesive. The bond strength of the wires to the adhesive was 20 N.

A cover layer of prepreg was laminated over the wire scribed circuit pattern at 160°C and 2.4 MPa. After laminating the cover layer, the wire pattern was examined for swimming and shrinkage, and compared to the wire pattern laminated onto the phenoxy based adhesive layer described above.

The results of this evaluation are outlined below:

| | Conventional Adhesive | Phenoxy based Adhesive |
|---|---|---|
| Wire swimming | slight | none |
| Wire Pattern Shrinkage | 0.67 mm/m | 0.07 mm/m |

After the cover layer prepreg had been laminated to the wire scribed circuit pattern, it was provided with a protective plating mask, drilled to form through-holes, plated so as to metallize the walls of said through-holes, and the protective plating mask was removed, all in accordance with methods well known in the art.

The insulation resistance of the thus formed wire scribed circuit board was then measured using the procedure outlined above. This was determined to be in the range of $10^4$ megohms (compared to $10^6$ megohms for the wire scribed circuit board made with phenoxy-based adhesive of this invention).

In a separate test, the volume resistivities of the conventional adhesive and of the phenoxy-based adhesive were measured. The results are reported below:

| | Conventional Adhesive | Phenoxy-based Adhesive |
|---|---|---|
| Volume resistitivity | $10^6$ megohm-cm | $10^8$ megohm-cm |

EXAMPLE II

Example I was repeated and similar results obtained using the following phenoxy coating composition as an adhesive layer for wire scribed circuit boards:

| | |
|---|---|
| 1. Phenoxy resin (same as in Example I) | 18.2 kg |
| 2. Blocked aliphatic polyisocyanate which will unblock at 100 to 110 °C. (The blocked polyisocyanate is 75% solids dissolved in a 50/50 mixture of xylene and 2-ethoxyethylacetate) | 2.38 kg |
| 3. Phlogopite mica powder (particle size of 80 microns) (same as in Example I) | 0.13 kg |
| 4. Zirconium silicate powder (average particle size 0.55 µm) same as in Example I | 0.13 kg |
| 5. Fumed silica (same as in Example I) | 0.053 kg |
| 6. Organic titanate coupling agent (same as in Example I) | 1.60 g |
| 7. Aluminum silicate clay (same as in Example I) | 0.22 kg |
| The above listed ingredients were mixed together in a high shear mixer (Cowles Dispersator™ ) for five min. and then an epoxy resin solution was added as follows: | |
| 8. Polyglycidylether of Bisphenol A (dry) (same as in Example I) | 2.22 kg |

EXAMPLES IIIA to IIIE

Example II is repeated five times except that the adhesive compositions are formulated as shown in the Table below. Example IIIA represents a phenoxy resin adhesive formulation similar to that of Example II except that the solvent employed will evaporate more quickly, thereby shortening the drying time.

Example IIIB represents an epoxy resin UV radiation curable adhesive formulation.

Example IIIC represents a B staging epoxy resin adhesive formulation.

Example IIID represents a phenoxy resin adhesive formulation similar to that of Example II except that it cures at a higher temperature (40 °C higher).

Example IIIE represents a polyester resin blocked polyisocyanate adhesive formulation.

In the formulation set forth in the Table for Example IIIC, instead of Epon 1009 ™ , there may be used an epoxy resin having an epoxy equivalent weight of 2 500 or an epoxy resin having an epoxy equivalent weight of 1 000.

In the formulation set forth in the Table for Example IIIC, instead of m-phenylene diamine, there may be used hydrazine or benzoguanamine as the B-staging curing agent for the epoxy resin.

TABLE OF ADHESIVE FORMULATIONS (EXAMPLES IIIA-IIIE)

| Component | IIIA | IIIB | IIIC | IIID | IIIE |
|---|---|---|---|---|---|
| An epoxy resin having an epoxy equivalent weight of 4 000 (EPON 1009™) | | | 100 g | | |
| Eponol 55-L-32 ™ | | 80 g | | | |
| Phenoxy resin, 30% solids, dissolved in propylene glycol monomethylether and methylethyl ketone. The phenoxyl resin is a poly [p,p-isopropylidene-diphenoxy-(hydroxyethyl)-ether] having from 23 to 350 monomer units per molecule and terminal epoxide or phenol groups, and has an $M_n$ of 20 000 (Eponol 55-B-30™) | 90 g | | | | |
| Polyglycidylether of bisphenol A with an $M_w$ of 44 000 and an $M_n$ of 11 000 as a 46% solution in a mixture of 92.5% 2-hydroxymethoxypropane and 7,5% methyl isobutylketone (RDX 67447™) | 10 g | | | 100 g | |
| Desmodur VP KL 5-2371 ™ | 32 g | | 33 g | | 30 g |
| A phenol blocked polyisocyanate adduct based upon toluene diisocyanate. The polyisocyanate is 100% solids (Desmodur AP STABIL™) | | | | 12 g | |
| m-phenylene diamine, a room temperature curing agent agent used for B-staging the epoxy resin | | | 2 g | | |
| Polyester adhesive resin with dihydroxy functionality and average molecular weight of 20 000 prepared from isophthalic and a nine carbon dibasic acid esterified with ethylene glycol and diethylglycol as a 52% solution in butanone (Adcote 76 PI™) | | | | | 100 g |
| Diglycidyl ether of bisphenol A having an epoxy equivalent weight of 190 (EPON 828™) | | 20 g | | | |
| Cationic UV curing agent for the epoxy resin, 50% solids in propylene carbonate (UVE 1014™) | | 2 - 5g | | | |

TABLE OF ADHESIVE FORMULATIONS (EXAMPLES IIIA-IIIE)
Cont'd.)

| COMPONENT | IIIA | IIIB | IIIC | IIID | IIIE' |
|---|---|---|---|---|---|
| Neopentyl diglycidyl ether, a reactive diluent plasticizer | | 5 g | 10 g | | |
| Methylethyl ketone, a solvent plasticizer | | | Amount sufficient to make 40% solids sol. | | |
| Propylene glycol monomethylether, a solvent plasticizer | Amount sufficient to permit composition to wet a surface | | | Amount sufficient to permit composition to wet a surface | |
| A high boiling petroleum oil plasticizer (Kenplast G™) | | | 10 g | | |
| A fumed silica (Cab-o-Sil™) | 1 - 2 g | 1 - 2 g | 1 - 2 g | 1 - 2 g | 1 - 2 g |
| Phlogopite mica powder (Suzorite™) | 2.5 - 5 g | 2.5 - 5 g | 2.5 - 5 g | 2.5 - 5 g | 2.5 - 5 g |
| Zirconium silicate (Excelopax™) | 2.5 - 5 g | 2.5 - 5 g | 2.5 - 5 g | 2.5 - 5 g | 2.5 - 5 g |
| Aluminum silicate clay (Cat 10™ powder) | 3.7 - 7 g | 3.7 - 7 g | 3.7 - 7 g | 3.7 - 7 g | 3.7 - 7 g |
| Organic titanate coupling agent (KR-238M™) | 0.03 g | 0.03 g | 0.03 g | 0.03 g | 0.03 g |

## Claims

**1.** A process for forming a wire scribed circuit wherein at least one adhesive layer is applied to a substrate and at least one wire conductor is scribed into the adhesive layer, characterized in that

(A) the wire conductor(s) is (are) adhesively bonded by application of sufficient heat or ultrasonic energy for a time period of less than 1 second, without C-staging the adhesive layer, and the adhesive layer is C-staged at a later process step; and
(B) the adhesive comprises, in combination,
(a) a first component comprised of a film forming polymeric resin having a number average molecular weight greater than 10 000 and a hydroxyl, epoxide or unsaturated functionality greater than 7, said resin being selected from the group of polyols consisting of polyesters, polyurethanes, phenoxies, epoxies and mixtures thereof;
(b) a second component comprised of a plasticizer present in an amount which permits the activation without curing the composition to the C-stage, said plasticizer being a volatile organic solvent having a boiling point above 100 °C, a reactive diluent which can be crosslinked with the polymeric resin, or mixtures thereof with an aromatic petroleum oil which does not volatilize or exude from the composition below 160 °C, said organic solvent being present in an amount less than 25% by weight of the adhesive composition; and
(c) a curing agent which is capable of reacting or initiating a reaction with the functional groups of the polymeric resin to form crosslinks and cure the polymeric resin to a C-stage upon application of sufficient energy in the form of radiant energy or heat at a temperature above the activation temperature of the composition for a time period sufficient to cure the polymeric resin, said curing agent being non-reactive or blocked at the conditions required to activate the adhesive composition, said curing agent being present in an amount sufficient to C-stage the polymeric resin; said composition being capable of converting in the C-stage into an infusible composition which does not melt or flow, upon exposure to a temperature up to about 200 °C and a pressure up to about 3 MPa, in a plane perpendicular to the direction of the applied pressure; and
(C) substantially all the solvent plasticizer is evaporated or substantially all the diluent plasticizer is reacted prior to the completion of the C-staging step; and
(D) after scribing the wire conductors into the adhesive layer, said layer is cured to C-stage the polymeric resin, thus preventing movement or swimming of the wire conductors subsequent to the wire scribing process.

**2.** The process of claim 1 wherein the polymeric resin of said adhesive composition is a linear phenoxy resin having the following recurring unit

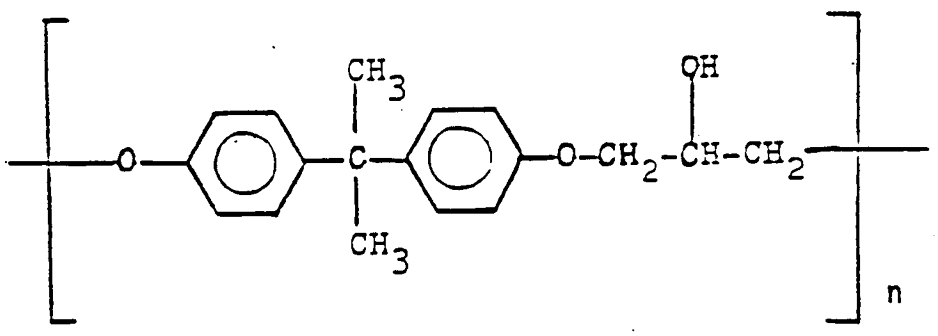

wherein n is an integer from 20 to 350.

**3.** The process of claim 1 wherein the functional groups of the polymeric resin are hydroxyl and the curing agent is a blocked isocyanate.

**4.** The process of claim 1 wherein the functional groups of the polymeric resin are unsaturated double bonds and the curing agent is a free radical initiator.

**5.** The process of claim 1 wherein the polymeric resin of said adhesive composition has been reacted to the B-stage with a second curing agent which was present either in less than a stoichiometric quantity or was capable of reacting with functional groups that were present at low concentrations on the polymer chain.

**6.** The process of claim 5 wherein the B-staged resin is formed by reacting a polyamine or polyamide

with a lower molecular weight polyepoxide compound.

**7.** The process of claim 5 wherein the B-staged resin has unsaturated functionality and the C-stage curing agent is a free radical initiator.

**8.** The process of claim 1 wherein two of said film forming polymeric resins of said adhesive composition are blended together.

**9.** The process of claim 1 wherein said plasticizer of said adhesive composition is an organic solvent selected from the group consisting of glycol ethers, glycol ether esters, ketones, aromatic hydrocarbons and substituted aromatic hydrocarbons.

**10.** The process of claim 1 wherein said reactive diluent of said adhesive composition is selected from the groups consisting of acrylate and methacrylate esters having boiling points above 100° C and low molecular weight mono- or diepoxide compounds.

**11.** The process of claim 1 wherein the adhesive composition is present as a film, said adhesive film being hot roll laminated onto the substrate, and the plasticizer in the adhesive composition is present in an amount which is sufficient to permit activation of the adhesive composition for the hot roll lamination step.

**12.** The process of claim 1 wherein the adhesive composition is present as a film, said film being vacuum laminated onto the substrate, and the plasticizer in the adhesive composition is present in an amount sufficient for the vacuum lamination step.

**13.** The process of claim 1 further comprising the step of laminating a protective coverlayer over said wire conductors, wherein said coverlayer is comprised of a second film comprised of said adhesive composition.

## Patentansprüche

**1.** Verfahren zum Herstellen einer drahtgeschriebenen Schaltung, bei dem mindestens eine Haftvermittlerschicht auf einen Träger aufgebracht wird und mindestens ein Drahtleiterzug in die Haftvermittlerschicht geschrieben wird, dadurch gekennzeichnet, daß

(A) der (die) Drahtleiterzug(züge) durch Einwirkung von ausreichend Wärme oder Ultraschallenergie für eine Zeitspanne von weniger als 1 Sekunde festhaftend verankert wird (werden), ohne die Haftvermittlerschicht in den C-Zustand zu bringen, und die Haftvermittlerschicht in einem späteren Verfahrensschritt in den C-Zustand gebracht wird; und

(B) der Haftvermittler in Kombination enthält:

(a) eine erste Komponente bestehend aus einem filmbildenden polymeren Harz mit einem mittleren Molekulargewicht größer als 10 000 und einer Hydroxyl-, Epoxid- oder ungesättigten Funktionalität größer als 7, und das genannte Harz ausgewählt ist aus der Gruppe der Polyole bestehend aus Polyestern, Polyurethanen, Phenoxys, Epoxys und Mischungen derselben;

(b) eine zweite Komponente bestehend aus einem Weichmacher in einer Menge, die die Aktivierung ohne Aushärten in den C-Zustand der Haftvermittlermischung erlaubt, und der genannte Weichmacher ein flüchtiges organisches Lösungsmittel mit einem Siedepunkt über 100° C ist, ein reaktionsfähiges Verdünnungsmittel, das mit dem polymeren Harz vernetzt werden kann, oder Mischungen derselben mit einem aromatischen Petroleum-Öl, das unter 160° C nicht flüchtig ist bzw. nicht aus der Abmischung austritt, und das genannte organische Lösungsmittel in einer Menge von weniger als 25 Gew.-% der Haftvermittlermischung vorhanden ist; und

(c) einen Härter, der in der Lage ist, mit den funktionalen Gruppen des polymeren Harzes zu reagieren oder eine Reaktion einzuleiten, um Vernetzungen zu bewirken und das polymere Harz in den C-Zustand zu überführen nach Zufuhr von ausreichend Energie in Form von Strahlung oder Wärme bei einer Temperatur über der Aktivierungstemperatur der Abmischung für eine Zeitspanne, die ausreicht, um das polymere Harz auszuhärten, und der genannte Härter nicht reaktiv oder geblockt ist unter den für die Aktivierung der Haftvermittlermischung erforderlichen Bedingungen, und der genannte Härter in einer Menge vorhanden ist, die ausreicht, um das polymere Harz in den C-Zustand überzuführen; und die genannte Abmischung in der Lage ist, im

C-Zustand in eine unschmelzbare Abmischung überzugehen, die bei einer Temperatur von bis zu 200 ° C und einem Druck von bis zu 3 MPa nicht schmilzt oder fließt in einer Ebene senkrecht zu der Richtung, in der der Druck einwirkt; und

(C) vor der vollständigen Überführung in den C-Zustand praktisch das gesamte Weichmacher-Lösungsmittel verdampft oder praktisch der gesamte Weichmacher-Verdünner zur Reaktion gebracht wird; und

(D) nach dem Schreiben der Drahtleiterzüge in die Haftvermittlerschicht diese ausgehärtet wird, um das Polymerharz in den C-Zustand zu bringen, wodurch das Bewegen oder Schwimmen der Drahtleiterzüge nach dem Drahtschreibevorgang vermieden wird.

**2.** Das Verfahren nach Anspruch 1, bei dem das polymere Harz der Haftvermittlermischung ein lineares Phenoxyharz ist mit der folgenden, sich wiederholenden Gruppeneinheit

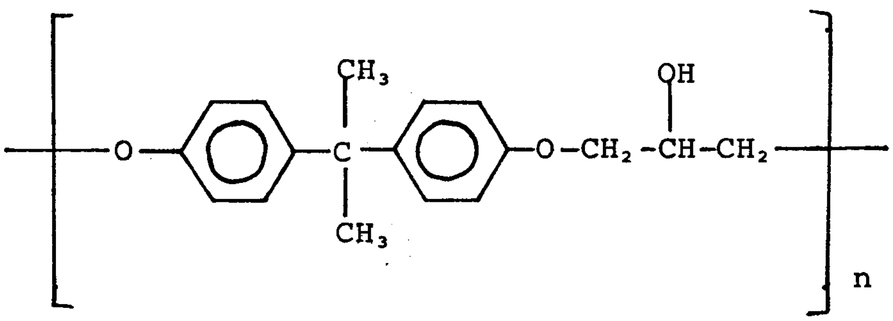

worin n eine ganze Zahl von 20 bis 350 ist.

**3.** Das Verfahren nach Anspruch 1, bei dem die Funktionsgruppen des polymeren Harzes Hydroxylgruppen sind und der Härter ein geblocktes Isocyanat.

**4.** Das Verfahren nach Anspruch 1, bei dem die Funktionsgruppen des polymeren Harzes ungesättigte Doppelbindungen sind und der Härter ein Initiator mit freien Radikalen.

**5.** Das Verfahren nach Anspruch 1, bei dem das polymere Harz der Haftvermittlermischung durch Reaktion mit einem zweiten Härter in den B-Zustand gebracht wird, wobei der zweite Härter entweder in einer geringeren als der stöchiometrischen Menge vorhanden war, oder in der Lage war, mit den Funktionsgruppen zu reagieren, die in geringen Konzentrationen in der Polymerkette vorhanden waren.

**6.** Das Verfahren nach Anspruch 5, bei dem das polymere Harz im B-Zustand durch Reaktion eines Polyamins oder Polyamids mit einer Polyepoxidkomponente mit geringerem Molekulargewicht gebildet wird.

**7.** Das Verfahren nach Anspruch 5, bei dem das polymere Harz im B-Zustand ungesättigte Funktionsgruppen aufweist und der Härter zur Überführung in den C-Zustand ein Initiator mit freien Radikalen ist.

**8.** Das Verfahren nach Anspruch 1, bei dem zwei der genannten filmbildenden polymeren Harze der Haftvermittlermischung miteinander vermischt sind.

**9.** Das Verfahren nach Anspruch 1, bei dem der Weichmacher in der Haftvermittlermischung ein organisches Lösungsmittel ist ausgewählt aus der Gruppe bestehend aus Glykolethern, Glykoletherestern, Ketonen, aromatischen Kohlenwasserstoffen und substituierten aromatischen Kohlenwasserstoffen.

**10.** Das Verfahren nach Anspruch 1, bei dem das reaktionsfähige Verdünnungsmittel in der Haftvermittlermischung ausgewählt ist aus den Gruppen bestehend aus Akrylat- und Methakrylatestern mit Siedepunkten über 100 ° C und Mono- oder Diepoxid-Komponenten mit niedrigem Molekulargewicht.

**11.** Das Verfahren nach Anspruch 1, bei dem die Haftvermittlermischung als Film vorliegt, und dieser

Haftvermittlerfilm mittels Heißwalzen-Laminieren auf dem Träger aufgebracht wird, und der Weichmacher in der Haftvermittlermischung in einer Menge vorhanden ist, die ausreicht, um diese für das Heißwalzen-Laminieren zu aktivieren.

**12.** Das Verfahren nach Anspruch 1, bei dem die Haftvermittlermischung als Film vorliegt, und dieser Film mittels Vakuum-Laminieren auf dem Träger aufgebracht wird, und der Weichmacher in der Haftvermittlermischung in einer Menge vorhanden ist, die für das Vakuum-Laminieren ausreicht.

**13.** Das Verfahren nach Anspruch 1, bei dem als weiterer Verfahrensschritt eine Abdeckschicht als Schutz über den Drahtleiterzügen auflaminiert wird, wobei die Abdeckschicht aus einem zweiten Film aus der genannten Haftvermittlermischung besteht.

**Revendications**

**1.** Procédé pour former un circuit gravé en fil dans lequel au moins une couche adhésive est appliquée à un substrat et au moins un conducteur en fil est gravé dans la couche adhésive, caractérisé en ce que :

(A) - le (les) conducteur (s) en fil est (sont) lié(s) de façon adhésive par application d'une chaleur ou d'une énergie ultrasonique suffisante pendant une durée inférieure à une seconde, sans stade C pour la couche adhésive, et la couche adhésive est soumise au stade C à une étape ultérieure du procédé ; et

(B) - l'adhésif comprend, en combinaison :

a) - un premier composant constitué d'une résine polymère filmogène ayant un poids moléculaire moyen en nombre supérieur à environ 10 000 et une fonctionnalité hydroxyle, époxyde ou insaturée supérieure à environ 7, ladite résine étant choisie dans le groupe des polyols constitués des polyesters, polyuréthanes, phénoxys, époxys et leurs mélanges ;

b) - un second composant constitué d'un plastifiant présent dans une quantité qui permet l'activation sans durcissement de la composition au stade C, ledit plastifiant étant un solvant organique volatil ayant un point d'ébullition supérieur à environ 100° C, un diluant réactif qui peut être réticulé avec la résine polymère ou leurs mélanges avec une huile de pétrole aromatique qui ne se volatilise pas ou n'exsude pas de la composition au-dessous d'environ 160° C, ledit solvant organique étant présent dans une quantité inférieure à environ 25% en poids de la composition adhésive ; et

c) - un agent de durcissement qui est capable de réagir ou d'amorcer une réaction avec les groupes fonctionnels de la résine polymère pour former des réticulations et durcir la résine polymère à un stade C lors de l'application d'une énergie suffisante sous la forme d'énergie ou de chaleur rayonnantes à une température supérieure à la température d'activation de la composition pendant une durée suffisante pour durcir la résine polymère, ledit agent de durcissement étant non-réactif ou bloqué dans les conditions requises pour activer la composition adhésive, ledit agent de durcissement étant présent dans une quantité suffisante pour faire subir le stade C à la résine polymère ; ladite composition pouvant être convertie lors du stage C en une composition infusible qui ne fond pas ou ne s'écoule pas, lors de l'exposition à une température atteignant environ 200° C et une pression atteignant environ 3 MPa, dans un plan perpendiculaire au sens de la pression appliquée ; et

C - la quasi totalité du plastifiant constituant le solvant est évaporée ou la quasi totalité du plastifiant constituant le diluant réagit avant l'achèvement de l'étape du stade C ; et

D - après gravure des conducteurs en fil dans la couche adhésive, ladite couche est durcie pour faire subir le stade C à la résine polymère, empêchant ainsi le mouvement ou le flottement des conducteurs en fil à la suite du processus de gravure de fil.

**2.** Procédé selon la revendication 1, dans lequel la résine polymère de ladite composition adhésive est une résine phénoxy linéaire ayant l'unité recurrente suivante :

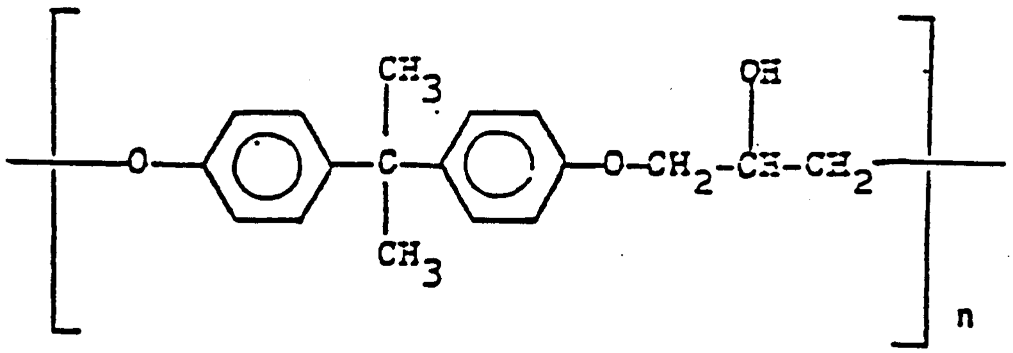

dans laquelle η est un nombre entier compris entre 20 et 350.

**3.** Procédé selon la revendication 1, dans lequel les groupes fonctionnels de la résine polymère sont des groupes hydroxyl et l'agent de durcissement est un isocyanate séquencé.

**4.** Procédé selon la revendication 1, dans lequel les groupes fonctionnels de la résine polymère sont des liaisons doubles insaturées et l'agent de durcissement est un initiateur de radicaux libres.

**5.** Procédé selon la revendication 1, dans lequel la résine polymère de ladite composition adhésive a été mis à réagir au stade B avec un second agent de durcissement qui soit était présent dans un rapport inférieur à la quantité stoechiométrique soit était capable de réagir avec des groupes fonctionnels qui étaient présents à de faibles concentrations sur la chaîne du polymère.

**6.** Procédé selon la revendication 5, dans lequel la résine ayant subi le stade B est formée en faisant réagir une polyamine ou un polyamide avec un composé de polyépoxide à faible masse moléculaire.

**7.** Procédé selon la revendication 5, dans lequel la résine ayant subi le stade B a une fonctionnalité insaturée et l'agent de durcissement au stade C est un initiateur de radicaux libres.

**8.** Procédé selon la revendication 1, dans lequel deux desdites résines polymères filmogènes de ladite composition adhésive sont mélangées ensemble.

**9.** Procédé selon la revendication 1, dans lequel ledit plastifiant de ladite composition adhésive est un solvant organique choisi dans le groupe constitué des glycoléthers, des esters de glycoléthers, des cétones, des hydrocarbures aromatiques et des hydrocarbures aromatiques substitués.

**10.** Procédé selon la revendication 1, dans lequel ledit diluant réactif de ladite composition adhésive est choisi dans les groupes constitués des esters d'acrylate et de méthacrylate ayant des points d'ébullition supérieurs à 100° C et des composés mono-ou di-époxides de faible masse moléculaire.

**11.** Procédé selon la revendication 1, dans lequel la composition adhésive est présente sous forme d'un film, ledit film adhésif étant laminé à chaud sur le substrat, et le plastifiant dans la composition adhésive est présent dans une quantité qui est suffisante pour permettre l'activation de la composition adhésive pour l'étape de laminage à chaud.

**12.** Procédé selon la revendication 1, dans lequel la composition adhésive est présente sous forme d'un film, ledit film étant laminé sous vide sur le substrat, et le plastifiant dans la composition adhésive est présent dans une quantité suffisante pour l'étape de laminage sous vide.

**13.** Procédé selon la revendication 1, comprenant en outre l'étape de laminage d'une couche supérieure de protection placée sur lesdits conducteurs en fil, où ladite couche supérieure est constituée d'un second film comprenant ladite composition adhésive.